# EUROPEAN PATENT APPLICATION

(11) **EP 4 495 736 A1**
(43) Date of publication of application: **22.01.2025**
(21) Application number: 24189688.5
(22) Date of filing: 19.07.2024
(51) Int. Cl.: G06F 1/20, G06F 1/3234

(54) **IMPROVED DATA THROUGHPUT USING TCM**

(30) Priority: 19.07.2023 IN 202311048260
(71) Applicant: Micron Technology, Inc., Boise, ID 83716 (US)
(72) Inventor: WILKINS, Kyle J., Meridian, 83642 (US); YARRAGUNTA, Suresh Reddy, 560059 Bangalore (IN); SUBHASH, Deepu Narasimiah, 560022 Yeshwanthpu (IN); AMITH, Koneri Sathyanarayana Guptha, 560043 Banaswadi (IN)
(74) Representative: Marks & Clerk LLP

(57) **Abstract**

Aspects of the present disclosure configure a memory sub-system processor to use a thermally conductive material (TCM) to improve thermal energy storage and heat dissipation to improve a data transfer rate. The TCM surrounds the set of memory components and the processing device and is configured to dissipate heat from the processing device and the set of memory components.

## Description

### TECHNICAL FIELD

Examples of the disclosure relate generally to memory sub-systems and, more specifically, to providing heat management and dissipation using a thermally conductive material (TCM).

### BACKGROUND

A memory sub-system can be a storage system, such as a solid-state drive (SSD), and can include one or more memory components that store data. The memory components can be, for example, non-volatile memory components and volatile memory components. In general, a host system can utilize a memory sub-system to store data on the memory components and to retrieve data from the memory components.

### BRIEF DESCRIPTION OF THE DRAWINGS

The present disclosure will be understood more fully from the detailed description given below and from the accompanying drawings of various embodiments of the disclosure.
**FIG. 1** is a block diagram illustrating an example computing environment including a memory sub-system, in accordance with some examples.
**FIG. 2** is a diagram of an example physical assembly of the memory sub-system with a TCM, in accordance with some examples.
**FIG. 3** is a block diagram of an example physical assembly of the memory controller with the TCM, in accordance with some examples.
**FIG. 4A** is a flow diagram of an example method to perform data throughput management and heat dissipation, in accordance with some examples.
**FIG. 4B** is a flow diagram of an example method to manufacture a physical assembly of the memory sub-system with a TCM, in accordance with some examples.
**FIG. 5** is a block diagram illustrating a diagrammatic representation of a machine in the form of a computer system within which a set of instructions can be executed for causing the machine to perform any one or more of the methodologies discussed herein, in accordance with some examples.

### DETAILED DESCRIPTION

Aspects of the present disclosure configure a system component, such as a memory sub-system processor or controller, such as a power management unit or module, to control data throughput (e.g., transfer between memory components and a host) based on heat that is dissipated through a TCM. In response to detecting that the temperature of the processor or the memory transgresses a threshold or reference temperature (e.g., 85 degrees Celsius), the memory sub-system processor or controller adjusts (e.g., throttles or reduces) the data throughput (the rate at which data is exchanged with a host or is transmitted from the processor to an external component) to reduce the temperature. When the temperature no longer transgresses the threshold or reference temperature, the processor or controller increases the data throughput. The temperature can be controlled (minimized or reduced) to prolong when the data throughput will be throttled or adjusted using a TCM that is physically deposited on a printed circuit board (PCB) implementing one of the memory sub-system components, such as the memory controller, memory components, and/or memory cells.

The TCM can be deposited to fully encapsulate any component on the PCB that has a height below a reference height restriction. The height of the TCM can correspond to a height of the memory controller chip and/or height of the memory component chips but may not exceed their heights. In this way, the TCM surrounds the memory controller chip and/or the memory component chips leaving their top surfaces entirely or partially exposed to the air. The TCM is configured to dissipate heat similar to a heat sink. This ensures that performance of the memory system remains optimal and avoids drastic data throughput throttling or reduction with minimal hardware additions. This improves thermal energy storage and the overall efficiency of operating and implementing the memory sub-system.

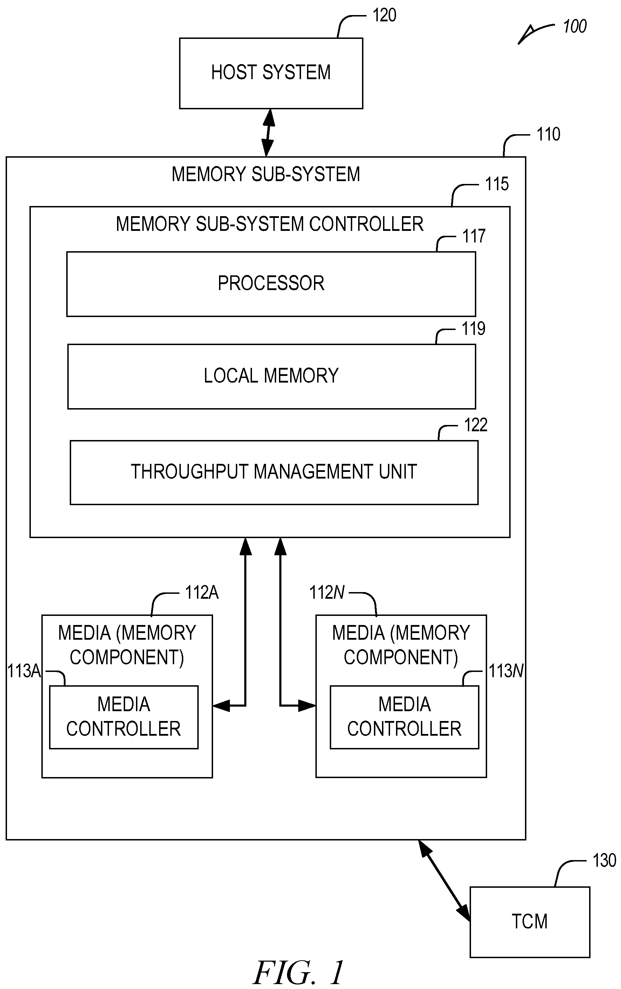

A memory sub-system can be a storage device, a memory module, or a hybrid of a storage device and memory module. Examples of storage devices and memory modules are described below in conjunction with FIG. 1. In general, a host system can utilize a memory sub-system that includes one or more memory components, such as memory devices (e.g., memory dies) that store data. The host system can send access requests (e.g., write command, read command) to the memory sub-system, such as to store data at the memory sub-system and to read data from the memory sub-system. The data (or set of data) specified by the host is hereinafter referred to as "host data," "application data," or "user data."

The memory sub-system can initiate media management operations, such as a write operation, on host data that is stored on a memory device. For example, firmware of the memory sub-system may re-write previously written host data from a location on a memory device to a new location as part of garbage collection management operations. The data that is re-written, for example as initiated by the firmware, is hereinafter referred to as "garbage collection data." "User data" can include host data and garbage collection data. "System data" hereinafter refers to data that is created and/or maintained by the memory sub-system for performing operations in response to host requests and for media management. Examples of system data include, and are not limited to, system tables (e.g., logical-to-physical address mapping table), data from logging, scratch pad data, etc.

Many different media management operations can be performed on the memory device. For example, the media management operations can include different scan rates, different scan frequencies, different wear leveling, different read disturb management, different near miss error correction (ECC), and/or different dynamic data refresh. Wear leveling ensures that all blocks in a memory component approach their defined erase-cycle budget at the same time, rather than some blocks approaching it earlier. Read disturb management counts all of the read operations to the memory component. If a certain threshold is reached, the surrounding regions are refreshed. Near-miss ECC refreshes all data read by the application that exceeds a configured threshold of errors. Dynamic data-refresh scan reads all data and identifies the error status of all blocks as a background operation. If a certain threshold of errors per block or ECC unit is exceeded in this scan-read, a refresh operation is triggered.

A memory device can be a non-volatile memory device. A non-volatile memory device is a package of one or more dice (or dies). Each die can be comprised of one or more planes. For some types of non-volatile memory devices (e.g., NAND devices), each plane is comprised of a set of physical blocks. For some memory devices, blocks are the smallest area than can be erased. Each block is comprised of a set of pages. Each page is comprised of a set of memory cells, which store bits of data. The memory devices can be raw memory devices (e.g., NAND), which are managed externally, for example, by an external controller. The memory devices can be managed memory devices (e.g., managed NAND), which are raw memory devices combined with a local embedded controller for memory management within the same memory device package.

There are challenges in efficiently managing or performing media management operations on typical memory devices in case of high temperature of the memory device and/or memory controller, such as when the internal temperature of the memory device/controller surpasses 85 degrees Celsius. Specifically, typical memory sub-systems are implemented on a PCB and distribute the components on the PCB in a way that minimizes heat build-up on certain components. Sometimes, specialized hardware, such as heat sinks, can be used that are physically attached to corresponding components to improve heat dissipation and cooling of the components. When the memory device/controller gets too hot (e.g., reaches a temperature that transgresses a threshold temperature), typical devices begin throttling or reducing the data throughput and can slow down certain operations in an attempt to lower the operating temperature. While these systems and approaches generally work well, the need to add these large heat sinks to reduce power can consume a great deal of physical real estate on the PCBs and can exceed the maximum allowable height that components on the PCB are allowed to reach. As a result, fewer memory components can be added and heat sinks cannot always be included, which causes the components to reach the threshold temperature very quickly, which reduces the overall data throughput and speed at which the memory sub-systems can operate.

Aspects of the present disclosure address the above and other deficiencies by providing a TCM that is thermally coupled to one or more memory components, such as a memory processor and/or memory dies or cells, which can improve heat dissipation and act as a heat sink while not violating any specifications, such as maximum height or PCB space restrictions. The TCM can collect heat dissipated by the memory components by physically and thermally touching or contacting physical components implementing the processor and/or memory components and transferring the heat to the air. In some examples, the TCM physically encapsulates certain components (e.g., active and/or passive components) that are implemented by physical chips that are lower in height than the maximum height restrictions. In some examples, the TCM physically encapsulates the processor and/or memory component chips up to their top surfaces without overlaying their top surfaces to avoid violating the maximum height restrictions. This provides a heat sink for the various components on the PCB without violating certain specifications and restrictions. In this way, the operating temperature of the memory system can be maintained at a relatively lower level (e.g., below the threshold temperature) for longer periods of time than typical systems which can prolong, delay, or prevent throttling of the data throughput and reduction in performance of the memory systems. This increases the efficiency of operating memory systems and can reduce the amount of physical resources consumed by the memory sub-systems and improves thermal energy storage.

In some examples, the memory controller (or throughput management unit) accesses a reference temperature for controlling data transfer throughput (e.g., data transfer rate between a host and the set of memory components). The controller measures temperature of at least one of the processing device or the set of memory components. Heat associated with the at least one of the processing device or the set of memory components can be dissipated at least in part through the TCM. The controller adjusts (e.g., increases or reduces) the data transfer throughput (e.g., the data transfer rate) based on comparing the measured temperature with the reference temperature.

In some examples, a PCB is provided on which the set of memory components, the processing device, and the TCM are implemented. In some examples, the processing device is implemented by a physical chip having a specified height relative to a top layer of the PCB, and a height of the TCM is less than or equal to the specified height of the physical chip. In some cases, the set of memory components is implemented by one or more physical chips each having a specified height relative to a top layer of the PCB, and a height of the TCM is less than or equal to the specified height of the one or more physical chips. In some examples, the specified height includes 1.5 millimeters.

In some examples, the PCB includes an M.2 interface through which the set of memory components and the processing device communicate with a host, the TCM being deposited on the PCB. In some cases, the PCB includes one or more passive or active components, and the TCM encapsulates the one or more passive or active components. In some examples, the TCM includes a heat sink.

In some examples, the TCM is thermally coupled to walls of physical chips that implement the processing device and the set of memory components. In some examples, the TCM includes a potting material including a thermal epoxy. In some cases, the thermal epoxy includes a 1 W/m-K thermal conductivity. In some cases, the TCM includes a phase change material (PCM). In some cases, the PCM includes a 0.7 W/m-K thermal conductivity.

In some examples, the TCM includes a first type of material and a second type of material. The first type of material can surround the processing device and the second type of material can surround the set of memory components. In some cases, a portion of the TCM is removable by applying a debonding liquid to access one or more circuit components covered by the TCM for debugging the memory sub-system. In some examples, the TCM is configured to absorb physical shock to the memory sub-system to add stability to the memory sub-system. In such cases, underfill material is excluded from being deposited underneath the set of memory components or the processing device.

In some examples, the techniques described herein relate to a method of manufacturing a PCB including a memory system. The method includes placing a processing device on a first portion of the PCB and placing a set of memory components of the memory system on a second portion of the PCB. The method includes depositing TCM on the PCB to surround the set of memory components and the processing device.

Though various embodiments are described herein as being implemented with respect to a memory sub-system (e.g., a controller of the memory sub-system), some or all of the portions of an embodiment can be implemented with respect to a host system, such as a software application or an operating system of the host system.

**FIG.** 1 illustrates an example computing environment 100 including a memory sub-system 110, in accordance with some examples. The memory sub-system 110 can include media, such as memory components 112A to 112*N* (also hereinafter referred to as "memory devices"). The memory components 112A to 112*N* can be volatile memory devices, non-volatile memory devices, or a combination of such. The memory components 112A to 112*N* can be implemented by individual dies, such that a first memory component 112A can be implemented by a first memory die (or a first collection of memory dies) and a second memory component 112N can be implemented by a second memory die (or a second collection of memory dies). These individual dies can be coupled to each other on an integrated circuit and placed as separate or combined components on a PCB.

In some examples, the memory sub-system 110 is a storage system. A memory sub-system 110 can be a storage device, a memory module, or a hybrid of a storage device and memory module. Examples of a storage device include a solid-state drive (SSD), a flash drive, a universal serial bus (USB) flash drive, an embedded Multi-Media Controller (eMMC) drive, a Universal Flash Storage (UFS) drive, and a hard disk drive (HDD). Examples of memory modules include a dual in-line memory module (DIMM), a small outline DIMM (SO-DIMM), and a non-volatile dual in-line memory module (NVDIMM).

The computing environment 100 can include a host system 120 that is coupled to a memory system. The memory system can include one or more memory sub-systems 110. In some examples, the host system 120 is coupled to different types of memory sub-systems 110. **FIG. 1** illustrates one example of a host system 120 coupled to one memory sub-system 110. The host system 120 uses the memory sub-system 110, for example, to write data to the memory sub-system 110 and read data from the memory sub-system 110. As used herein, "coupled to" generally refers to a connection between components, which can be an indirect communicative connection or direct communicative connection (e.g., without intervening components), whether wired or wireless, including connections such as electrical, optical, magnetic, etc.

The host system 120 can be a computing device such as a desktop computer, laptop computer, network server, mobile device, embedded computer (e.g., one included in a vehicle, industrial equipment, or a networked commercial device), or such computing device that includes a memory and a processing device. The host system 120 can include or be coupled to the memory sub-system 110 so that the host system 120 can read data from or write data to the memory sub-system 110. The host system 120 can be coupled to the memory sub-system 110 via a physical host interface. Examples of a physical host interface include, but are not limited to, a serial advanced technology attachment (SATA) interface, a peripheral component interconnect express (PCIe) interface, a USB interface, a Fibre Channel interface, a Serial Attached SCSI (SAS) interface, an M.2 SSD interface, etc. The physical host interface can be used to transmit data between the host system 120 and the memory sub-system 110. The host system 120 can further utilize an NVM Express (NVMe) interface to access the memory components 112A to 112*N* when the memory sub-system 110 is coupled with the host system 120 by the PCIe interface and/or M.2 SSD interface. The physical host interface can provide an interface for passing control, address, data, and other signals between the memory sub-system 110 and the host system 120. The memory sub-system 110 can be implemented on a PCB that is coupled to the host system 120 via a specified interface, such as the M.2 SSD interface.

The memory components 112A to *112N* can include any combination of the different types of non-volatile memory components and/or volatile memory components. An example of non-volatile memory components includes a negative- and (NAND)-type flash memory. Each of the memory components 112A to 112*N* can include one or more arrays of memory cells such as single-level cells (SLCs) or multilevel cells (MLCs) (e.g., TLCs or QLCs). In some cases, a particular memory component 112 can include both an SLC portion and an MLC portion of memory cells. Each of the memory cells can store one or more bits of data (e.g., blocks) used by the host system 120. Although non-volatile memory components such as NAND-type flash memory are described, the memory components 112A to 112*N* can be based on any other type of memory, such as a volatile memory. In some examples, the memory components 112A to 112*N* can be, but are not limited to, random access memory (RAM), read-only memory (ROM), dynamic random-access memory (DRAM), synchronous dynamic random access memory (SDRAM), phase change memory (PCM), magnetoresistive random access memory (MRAM), negative-or (NOR) flash memory, electrically erasable programmable read-only memory (EEPROM), and a cross-point array of non-volatile memory cells.

A cross-point array of non-volatile memory cells can perform bit storage based on a change of bulk resistance, in conjunction with a stackable cross-gridded data access array. Additionally, in contrast to many flash-based memories, cross-point non-volatile memory can perform a write-in-place operation, where a non-volatile memory cell can be programmed without the non-volatile memory cell being previously erased. Furthermore, the memory cells of the memory components 112A to 112*N* can be grouped as memory pages or blocks that can refer to a unit of the memory component 112 used to store data.

The memory sub-system controller 115 can communicate with the memory components 112A to 112*N* to perform memory operations such as reading data, writing data, or erasing data at the memory components 112A to *112N* and other such operations. The memory sub-system controller 115 can communicate with the memory components 112A to 112*N* to perform various memory management operations, such as different scan rates, different scan frequencies, different wear leveling, different read disturb management, different near miss ECC operations, and/or different dynamic data refresh.

The memory sub-system controller 115 can include hardware such as one or more integrated circuits and/or discrete components, a throughput management unit 122, a TCM 130, a buffer memory, and/or a combination thereof. The memory sub-system controller 115 can be a microcontroller, special-purpose logic circuitry (e.g., a field programmable gate array (FPGA), an application specific integrated circuit (ASIC), etc.), or another suitable processor. The memory sub-system controller 115 can include a processor (processing device) 117 configured to execute instructions stored in local memory 119. In the illustrated example, the local memory 119 of the memory sub-system controller 115 includes an embedded memory configured to store instructions for performing various processes, operations, logic flows, and routines that control operation of the memory sub-system 110, including handling communications between the memory sub-system 110 and the host system 120. In some cases, the local memory 119 can include memory registers storing memory pointers, fetched data, and so forth. The local memory 119 can also include ROM for storing microcode with instructions for the memory sub-system controller 115 to execute, such as firmware. While the example memory sub-system 110 in **FIG.** 1 has been illustrated as including the memory sub-system controller 115, in another example of the present disclosure, a memory sub-system 110 may not include a memory sub-system controller 115, and can instead rely upon external control (e.g., provided by an external host, or by a processor 117 or controller separate from the memory sub-system 110).

In general, the memory sub-system controller 115 can receive commands or operations from the host system 120 and can convert the commands or operations into instructions or appropriate commands to achieve the desired access to the memory components 112A to 112*N*. The memory sub-system controller 115 can be responsible for other memory management operations, such as wear leveling operations, garbage collection operations, error detection and error-correcting code (ECC) operations, encryption operations, caching operations, memory components 112A to 112*N* initialization, and/or address translations. The memory sub-system controller 115 can further include host interface circuitry to communicate with the host system 120 via the physical host interface. The host interface circuitry can convert the commands received from the host system 120 into command instructions to access the memory components 112A to 112*N* as well as convert responses associated with the memory components 112A to 112*N* into information for the host system 120. The memory sub-system controller 115 can include a memory interface to communicate with the memory components 112A to 112*N*. Any component included as part of the memory sub-system controller 115 can be included in the memory interface and vice versa.

The memory sub-system 110 can also include additional circuitry or components that are not illustrated, such as capacitors, resistors, transistors, and various other active or passive devices. In some examples, the memory sub-system 110 can include a cache or buffer (e.g., DRAM or other temporary storage location or device) and address circuitry (e.g., a row decoder and a column decoder) that can receive an address from the memory sub-system controller 115 and decode the address to access the memory components 112A to 1127V.

The memory devices can be raw memory devices (e.g., NAND), which are managed externally, for example, by an external controller (e.g., memory sub-system controller 115). The memory devices can be managed memory devices (e.g., managed NAND), which are raw memory devices combined with a local embedded controller (e.g., local media controllers) for memory management within the same memory device package. Any one of the memory components 112A to 112*N* can include a media controller (e.g., media controller 113A and media controller 113N) to manage the memory cells of the memory component (e.g., to perform one or more memory management operations), to communicate with the memory sub-system controller 115, and to execute memory requests (e.g., read or write) received from the memory sub-system controller 115.

The memory sub-system controller 115 can include a throughput management unit 122 that is coupled to a TCM 130. In some cases, the throughput management unit 122 can be a separate physical component from the components of the memory sub-system controller 115. In some cases, the throughput management unit 122 and the components of the memory sub-system controller 115 are implemented by the same physical device or integrated circuit. The TCM 130 is a separate physical device, material, and/or layer (or combination of layers) from the throughput management unit 122 and/or the memory sub-system controller 115. The TCM 130 implements a heat sink that is configured to draw or receive heat from one of the components of the memory sub-system 110 and dissipate such heat to the air or other fluid or gas to cool components of the memory sub-system 110.

In some examples, the TCM 130 can be implemented by a material (e.g., a potting material, such as epoxies (e.g., with 1.48 W/mK), urethanes (e.g., with 2.5 W/mK or 0.2 W/mK), silicone adhesives, a thermal epoxy with a 1 W/m-K thermal conductivity and/or a phase change material with a 0.7 W/m-K thermal conductivity) coupled to a ground layer of a PCB on which the memory sub-system 110 is implemented. In such cases, the TCM 130 can be any combination of a first type of material (e.g., potting material) and/or a second type of material (e.g., a PCM). Heat can be transferred to the TCM 130 by having thermal contact between the TCM 130 and individual components on the PCB. Such heat can be dissipated to the external fluid or gas. In this way, the TCM 130 acts as a heat sink, and temperature of the memory sub-system 110 can be reduced or maintained at a relatively low level to prevent the throughput management unit 122 from reducing throughput of the memory sub-system 110 in response to detecting that the temperature of one or more components of the memory sub-system 110 transgresses a temperature threshold or reference temperature. This keeps the data rate operating at the optimal or maximum level which improves the overall efficiency and functioning of the device. In some examples, the TCM 130 can collect heat dissipated by one or more components of the memory sub-system controller 115 and/or the memory sub-system 110, such as the memory components 112A to 112N.

Depending on the example, the throughput management unit 122 can comprise logic (e.g., a set of transitory or non-transitory machine instructions, such as firmware) or one or more components that cause the throughput management unit 122 to perform operations described herein. The throughput management unit 122 can comprise a tangible or non-tangible unit capable of performing operations described herein.

For example, the throughput management unit 122 can be configured to access a reference temperature for controlling data transfer throughput (data transfer rate between a host and the memory sub-system). The throughput management unit 122 measures temperature of at least one of the processing device or the set of memory components. Heat associated with the at least one of the components of the memory sub-system 110 can be dissipated at least in part through the TCM 130 that is thermally coupled to the processing device and the set of memory components. The throughput management unit 122 adjusts or reduces the data transfer throughput in response to determining that the measured temperature transgresses the reference temperature. The throughput management unit 122 adjusts or increases the data transfer throughput in response to determining that the measured temperature no longer transgresses or fails to transgress the reference temperature.

In some examples, a PCB is provided on which the set of memory components, the processing device, and the TCM 130 (and various other components of the memory sub-system 110) are implemented. In some examples, the PCB includes a plurality of layers each accessible through one or more vias, the plurality of layers including a ground layer. The set of memory components and the processing device are both surrounded (partially and/or entirely) by the TCM 130, excluding their top surfaces. Other active or passive components (e.g., resistors, capacitors, inductors, and/or transistors) that are smaller in height than the set of memory components and the processing device can be fully encapsulated by the TCM 130. In some cases, the TCM 130 is made up of a first material type that physically and thermally surrounds the set of memory components and is made up of a second material type that physically and thermally surrounds the processing device.

In some examples, a height of the TCM 130 can be less than or equal to a specified/maximum height of one or more physical chips on the PCB. Namely, the height of the TCM 130 relative to a base or top surface of the PCB on which the TCM 130 is deposited can be no greater than a height of the tallest physical component placed on the same PCB relative to the top surface of the PCB. In some examples, the set of memory components is implemented by a physical chip having a specified height relative to a top layer of the PCB. A height of the TCM 130 can be less than or equal to the specified height of the physical chip. In some examples, the specified height includes 1.5 millimeters or less.

In some examples, the PCB includes an M.2 interface through which the set of memory components and the throughput management unit 122 communicate with the host system 120. In some examples, the TCM 130 includes a heat sink. In some examples, the TCM 130 is disposed on the PCB in a region between the processing device and the set of memory components. In some examples, a debonding liquid can be applied to some portions of the TCM 130 or all portions of the TCM 130. This debonding liquid can be used to remove some or all portions of the TCM 130 to allow direct physical access to the underlying physical components. This can be done to perform debugging operations or functions. Following completion of the debugging operations or functions, the TCM 130 can again be deposited in the portions of the PCB from which the TCM 130 was removed by the debonding liquid.

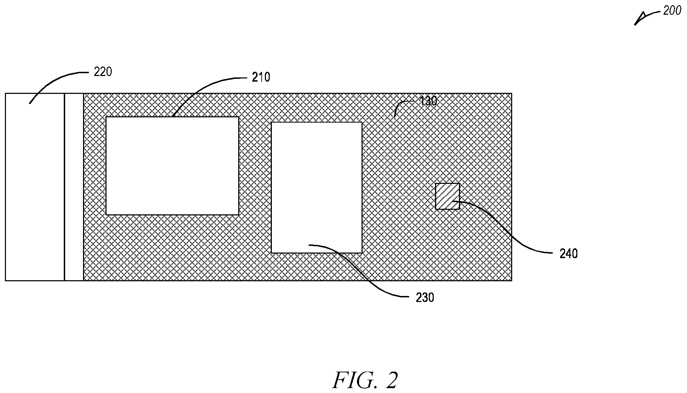

**FIG.** 2 is a diagram 200 of an example physical assembly or PCB on which the memory sub-system 110 and the TCM 130 are implemented, in accordance with some examples. The PCB shown in the diagram 200 includes an interface 220 (e.g., an M.2 interface), a control component 210, a memory component 230, and the TCM 130.

The control component 210 can include a physical chip or integrated circuit package in which any one of the components of the memory sub-system 110 can be implemented, such as the memory sub-system controller 115. The memory component 230 can include one or more physical chips or integrated circuit packages in which any one of the memory components 112 is implemented. The memory sub-system 110 communicates with the host system 120 via the interface 220. In some cases, the memory sub-system 110 communicates with the host system 120 at a first throughput or data rate. When the throughput management unit 122 determines that a temperature of the control component 210 and/or the memory component 230 reaches or transgresses a temperature threshold or reference temperature, the throughput management unit 122 can throttle or reduce the data rate so that the memory sub-system 110 communicates with the host system 120 at a second throughput or data transfer rate. This allows the throughput management unit 122 to reduce the operating temperature of the memory sub-system 110 to continue operating without having to shut down any component.

In order to increase the amount of time it takes the memory sub-system 110 to reach the temperature threshold or reference temperature from an ambient temperature, the PCB includes the TCM 130. The TCM 130 is thermally coupled physically to one or more of the control component 210, memory component 230, passive/active component(s) 240, and/or the interface 220. The TCM 130 can be a thermally conductive material that is also an electrical insulator.

In some examples, the interface 220 is associated with a height restriction. The height restriction limits the total height (e.g., vertical distance between a surface of the PCB and a top portion of any component placed on the PCB). In such cases, the distance or vertical displacement between the surface of the PCB and the top portion of each component on the PCB (including the TCM 130 that is deposited on the PCB) is set to not exceed the total height of the height restriction. The TCM 130 can be distributed throughout the PCB on various empty portions, such as between the control component 210 and the memory component 230.

In some examples, the component(s) 240 can include physical components that have a height that is smaller than a height of the control component 210 and/or the memory component 230. In such cases, the TCM 130 is deposited on top of the component(s) 240 to completely encapsulate the component(s) 240. The diagonal lines in diagram 200 with respect to component(s) 240 illustrate that the component(s) 240 are completely encapsulated by the TCM 130 while a top surface of each of the control component 210 and/or the memory component 230 remains exposed to the air and is not covered at all by the TCM 130. The TCM 130 surrounds the control component 210 and/or the memory component 230 including physically and thermally touching walls of the chips or physical components implementing control component 210 and/or the memory component 230.

In some examples, a first portion of the TCM 130 can be of a first type of material. The first portion of the TCM 130 can physically surround at least a portion of the control component 210. A second portion of the TCM 130 can be of a second type of material. The second portion of the TCM 130 can physically surround at least a portion of the memory component 230. In some cases, a first portion of the control component 210 (and/or the memory component 230) can be surrounded by the first type of material of the TCM 130 and a second portion of the control component 210 (and/or the memory component 230) can be surrounded by the second type of material of the TCM 130.

In some examples, a debugging operation may need to be performed for the PCB shown in **FIG. 2****.** The debugging operation may need access to component portions that are covered at least partially by the TCM 130. In such cases, a debonding liquid can be deposited on a portion of the TCM 130 to remove the portion of the TCM 130. This exposes the physical component that is covered by the portion of the TCM 130 and allows the debugging operations to be performed. Once debugging has been completed, the portion can again be filled by the TCM 130 of the same type of material that was removed or by a different type of material that was removed.

In some examples, the control component 210 and/or the memory component 230 can be placed on the PCB without first depositing underfill material. Namely, the control component 210 and/or the memory component 230 can be placed directly on the PCB without being placed on top of underfill material that is usually included under the control component 210 and/or the memory component 230 to absorb physical shock. Because the underfill material is excluded, the TCM 130 can be deposited to not only absorb heat but also to absorb and reduce physical shock to which the control component 210 and/or the memory component 230 can be exposed. This improves the overall reliability and performance of the memory sub-system 110. In this way, the TCM 130 can reduce cost of producing the PCB because the underfill material can be excluded and replaced by the TCM 130.

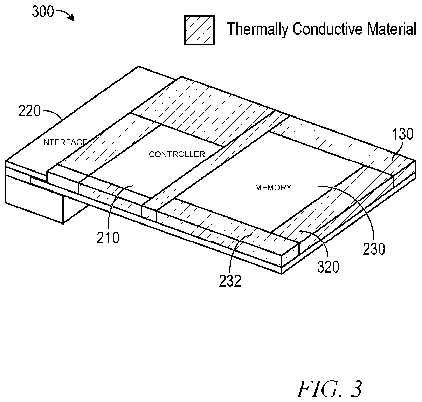

**FIG. 3** is a block diagram of an example physical assembly 300 of the memory controller with the TCM, in accordance with some examples. **FIG. 3** shows a cross-sectional view or perspective of PCB shown in the diagram 200 which shows a top down view of the PCB on which the TCM 130 is implemented/deposited. Components from **FIG. 2** are similarly labeled in **FIG. 3****.**

As shown in **FIG. 3****,** the interface 220 can be associated with a height restriction. The height restriction can specify a maximum height 232 that any individual component placed on the PCB can have. For example, the memory component 230 can be implemented by a physical chip having a height measured from a surface of the PCB to a top of the physical chip that is less than or equal to the maximum height 232.

The TCM 130 includes a material that is deposited on top of all of the components of the PCB. The TCM 130 can completely encapsulate some passive/active components 320 but only cover the side walls of the control component 210 and the memory component 230 leaving their top surfaces exposed to the air. In this way, heat can be collected or transferred from the interface 220, control component 210, memory component 230, and/or active components 320 through the TCM 130. The heat is then dissipated to a fluid or gas that touches the TCM 130.

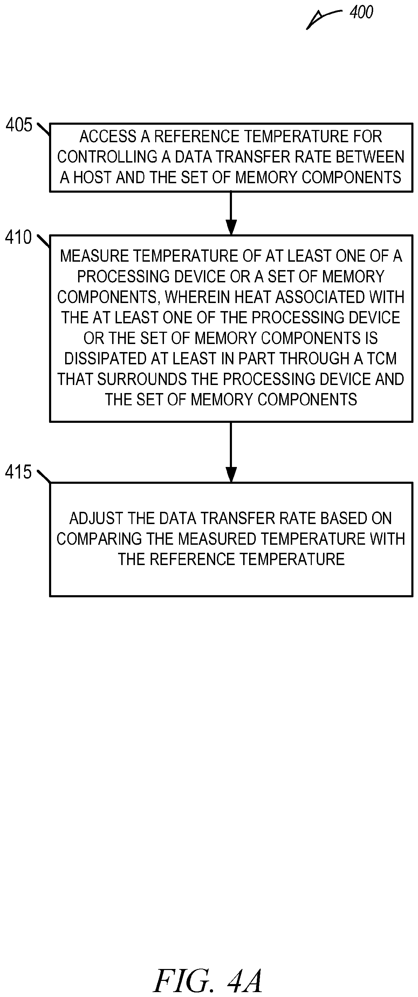

**FIG. 4A** is a flow diagram of an example method (or process) to perform data throughput management and heat dissipation, in accordance with some implementations of the present disclosure. The method 400 can be performed by processing logic that can include hardware (e.g., a processing device, circuitry, dedicated logic, programmable logic, microcode, hardware of a device, an integrated circuit, etc.), software (e.g., instructions run or executed on a processing device), or a combination thereof. In some examples, the method 400 is performed by the throughput management unit 122 of **FIG. 1****.** Although the processes are shown in a particular sequence or order, unless otherwise specified, the order of the processes can be modified. Thus, the illustrated examples should be understood only as examples, and the illustrated processes can be performed in a different order, and some processes can be performed in parallel. Additionally, one or more processes can be omitted in various examples. Thus, not all processes are required in every example. Other process flows are possible.

Referring now to **FIG. 4A****,** the method (or process) 400 begins at operation 405, with a throughput management unit 122 of a memory sub-system (e.g., memory sub-system 110) accessing a reference temperature for controlling a data transfer rate between a host and the set of memory components. Then, the throughput management unit 122 measures a temperature of at least one of a processing device (e.g., memory sub-system controller 115) or a set of memory components 112 at operation 410. In an example, heat associated with at least one of a processing device (e.g., memory sub-system controller 115) or the set of memory components 112 is dissipated at least in part through a TCM 130 that surrounds the at least one of a processing device (e.g., memory sub-system controller 115) and a set of memory components 112. At operation 415, the throughput management unit 122 adjusts the data transfer rate based on comparing the measured temperature with the reference temperature (e.g., reduces the data transfer rate in response to determining that the temperature transgresses (exceeds by more than a specified amount) the reference temperature).

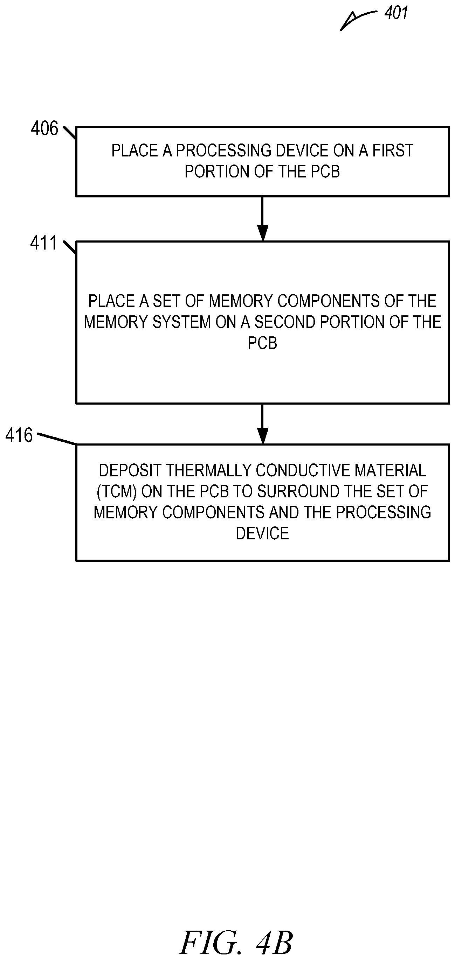

**FIG. 4B** is a flow diagram of an example method (or process) to manufacture a physical assembly of the memory sub-system with a TCM, in accordance with some implementations of the present disclosure. The method 401 can be performed by processing logic that can include hardware (e.g., a processing device, circuitry, dedicated logic, programmable logic, microcode, hardware of a device, an integrated circuit, etc.), software (e.g., instructions run or executed on a processing device), or a combination thereof. Although the processes are shown in a particular sequence or order, unless otherwise specified, the order of the processes can be modified. Thus, the illustrated examples should be understood only as examples, and the illustrated processes can be performed in a different order, and some processes can be performed in parallel. Additionally, one or more processes can be omitted in various examples. Thus, not all processes are required in every example. Other process flows are possible.

Referring now to **FIG. 4B****,** the method (or process) 401 begins at operation 406, with a processing device being placed on a first portion of a PCB and, at operation 411, a set of memory components 112 being placed on a second portion of the PCB. Then, a TCM 130 is deposited on the PCB is connected to surround the set of memory components and the processing device at operation 416.

In view of the disclosure above, various examples are set forth below. It should be noted that one or more features of an example, taken in isolation or combination, should be considered within the disclosure of this application.

Example 1. A system comprising: a set of memory components of a memory sub-system; a processing device operatively coupled to the set of memory components; and a TCM surrounding the set of memory components and the processing device, the TCM configured to dissipate heat from the processing device and the set of memory components, wherein the processing device is configured to perform operations comprising: measuring temperature of at least one of the processing device or the set of memory components; accessing a reference temperature for controlling data transfer rate between a host and the set of memory components; comparing the measured temperature with the reference temperature; and adjusting the data transfer rate based on the comparing the measured temperature with the reference temperature.

Example 2. The system of Example 1, comprising a PCB on which the set of memory components, the processing device, and the TCM are implemented.

Example 3. The system of Example 2, wherein the processing device is implemented by a physical chip having a specified height relative to a top layer of the PCB, and wherein a height of the TCM is less than or equal to the specified height of the physical chip.

Example 4. The system of any one of Examples 2-3, wherein the set of memory components is implemented by one or more physical chips each having a specified height relative to a top layer of the PCB, and wherein a height of the TCM is less than or equal to the specified height of the one or more physical chips.

Example 5. The system of Example 4, wherein the specified height comprises 1.5 millimeters.

Example 6. The system of any one of Examples 1-5, wherein a PCB comprises an M.2 interface through which the set of memory components and the processing device communicate with a host, the TCM being deposited on the PCB.

Example 7. The system of Example 6, wherein the PCB comprises one or more passive or active components, and wherein the TCM encapsulates the one or more passive or active components.

Example 8. The system of any one of Examples 1-7, wherein the TCM comprises a heat sink.

Example 9. The system of any one of Examples 1-8, wherein the TCM is thermally coupled to walls of physical chips that implement the processing device and the set of memory components.

Example 10. The system of any one of Examples 1-9, wherein the TCM comprises a potting material comprising a thermal epoxy.

Example 11. The system of Example 10, wherein the thermal epoxy comprises a 1 W/m-K thermal conductivity.

Example 12. The system of any one of Examples 1-11, wherein the TCM comprises a PCM.

Example 13. The system of Example 12, wherein the PCM comprises a 0.7 W/m-K thermal conductivity.

Example 14. The system of any one of Examples 1-13, wherein the TCM comprises a first type of material and a second type of material, the first type of material surrounding the processing device and the second type of material surrounding the set of memory components.

Example 15. The system of any one of Examples 1-14, wherein a portion of the TCM is removable by applying a debonding liquid to access one or more circuit components covered by the TCM for debugging the memory sub-system.

Example 16. The system of any one of Examples 1-15, wherein the TCM is configured to absorb physical shock to the memory sub-system to add stability to the memory sub-system, and wherein underfill material is excluded from being deposited underneath the set of memory components or the processing device.

Example 17. A method comprising: measuring temperature of at least one of a processing device or a set of memory components, wherein heat associated with the at least one of the processing device or the set of memory components is dissipated at least in part through a TCM that surrounds the set of memory components and the processing device; accessing a reference temperature for controlling a data transfer rate between a host and the set of memory components; comparing the measured temperature with the reference temperature; and adjusting the data transfer rate based on the comparing the measured temperature with the reference temperature.

Example 18. The method of Example 17, wherein the processing device is implemented by a physical chip having a specified height relative to a top layer of a PCB, and wherein a height of the TCM is less than or equal to the specified height of the physical chip.

Example 19. The method of Example 18, wherein the set of memory components is implemented by one or more physical chips each having a specified height relative to a top layer of the PCB, and wherein a height of the TCM is less than or equal to the specified height of the one or more physical chips.

Example 20. A method of manufacturing a PCB comprising a memory system, the method comprising: placing a processing device on a first portion of the PCB; placing a set of memory components of the memory system on a second portion of the PCB; and depositing TCM on the PCB to surround the set of memory components and the processing device.

Methods and computer-readable storage medium with instructions for performing any one of the above examples.

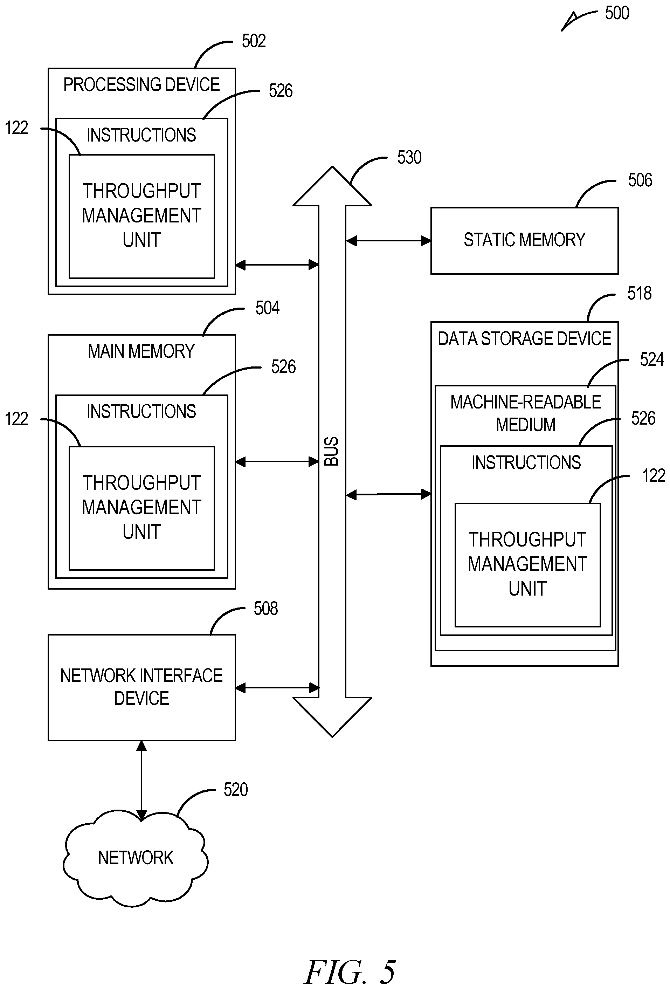

**FIG. 5** illustrates an example machine in the form of a computer system 500 within which a set of instructions can be executed for causing the machine to perform any one or more of the methodologies discussed herein. In some embodiments, the computer system 500 can correspond to a host system (e.g., the host system 120 of **FIG. 1**) that includes, is coupled to, or utilizes a memory sub-system (e.g., the memory sub-system 110 of **FIG. 1**) or can be used to perform the operations of a controller (e.g., to execute an operating system to perform operations corresponding to the throughput management unit 122 of **FIG. 1**). In alternative embodiments, the machine can be connected (e.g., networked) to other machines in a local area network (LAN), an intranet, an extranet, and/or the Internet. The machine can operate in the capacity of a server or a client machine in a client-server network environment, as a peer machine in a peer-to-peer (or distributed) network environment, or as a server or a client machine in a cloud computing infrastructure or environment.

The machine can be a personal computer (PC), a tablet PC, a set-top box (STB), a Personal Digital Assistant (PDA), a cellular telephone, a web appliance, a server, a network router, a network switch, a network bridge, or any machine capable of executing a set of instructions (sequential or otherwise) that specify actions to be taken by that machine. Further, while a single machine is illustrated, the term "machine" shall also be taken to include any collection of machines that individually or jointly execute a set (or multiple sets) of instructions to perform any one or more of the methodologies discussed herein.

The example computer system 500 includes a processing device 502, a main memory 504 (e.g., ROM, flash memory, DRAM such as SDRA) or Rambus DRAM (RDRAM), etc.), a static memory 506 (e.g., flash memory, static random access memory (SRAM), etc.), and a data storage system 518, which communicate with each other via a bus 530.

The processing device 502 represents one or more general-purpose processing devices such as a microprocessor, a central processing unit, or the like. More particularly, the processing device 502 can be a complex instruction set computing (CISC) microprocessor, a reduced instruction set computing (RISC) microprocessor, a very long instruction word (VLIW) microprocessor, a processor implementing other instruction sets, or processors implementing a combination of instruction sets. The processing device 502 can also be one or more special-purpose processing devices such as an application specific integrated circuit (ASIC), a field programmable gate array (FPGA), a digital signal processor (DSP), a network processor, or the like. The processing device 502 is configured to execute instructions 526 for performing the operations and steps discussed herein. The computer system 500 can further include a network interface device 508 to communicate over a network 520.

The data storage system 518 can include a machine-readable storage medium 524 (also known as a computer-readable medium) on which is stored one or more sets of instructions 526, or software embodying any one or more of the methodologies or functions described herein. The instructions 526 can also reside, completely or partially, within the main memory 504 and/or within the processing device 502 during execution thereof by the computer system 500, the main memory 504 and the processing device 502 also constituting machine-readable storage media. The machine-readable storage medium 524, data storage system 518, and/or main memory 504 can correspond to the memory sub-system 110 of **FIG. 1****.**

In one embodiment, the instructions 526 implement functionality corresponding to the throughput management unit 122 of **FIG. 1****.** While the machine-readable storage medium 524 is shown in an example embodiment to be a single medium, the term "machine-readable storage medium" should be taken to include a single medium or multiple media that store the one or more sets of instructions. The term "machine-readable storage medium" shall also be taken to include any medium that is capable of storing or encoding a set of instructions for execution by the machine and that cause the machine to perform any one or more of the methodologies of the present disclosure. The term "machine-readable storage medium" shall accordingly be taken to include, but not be limited to, solid-state memories, optical media, and magnetic media.

Some portions of the preceding detailed descriptions have been presented in terms of algorithms and symbolic representations of operations on data bits within a computer memory. These algorithmic descriptions and representations are the ways used by those skilled in the data processing arts to convey the substance of their work most effectively to others skilled in the art. An algorithm is here, and generally, conceived to be a self-consistent sequence of operations leading to a desired result. The operations are those requiring physical manipulations of physical quantities. Usually, though not necessarily, these quantities take the form of electrical or magnetic signals capable of being stored, combined, compared, and otherwise manipulated. It has proven convenient at times, principally for reasons of common usage, to refer to these signals as bits, values, elements, symbols, characters, terms, numbers, or the like.

It should be borne in mind, however, that all of these and similar terms are to be associated with the appropriate physical quantities and are merely convenient labels applied to these quantities. The present disclosure can refer to the action and processes of a computer system, or similar electronic computing device, that manipulates and transforms data represented as physical (electronic) quantities within the computer system's registers and memories into other data similarly represented as physical quantities within the computer system's memories or registers or other such information storage systems.

The present disclosure also relates to an apparatus for performing the operations herein. This apparatus can be specially constructed for the intended purposes, or it can include a general-purpose computer selectively activated or reconfigured by a computer program stored in the computer. Such a computer program can be stored in a computer-readable storage medium, such as, but not limited to, any type of disk including floppy disks, optical disks, CD-ROMs, and magnetic-optical disks; ROMs; RAMs; erasable programmable read-only memories (EPROMs); EEPROMs; magnetic or optical cards; or any type of media suitable for storing electronic instructions, each coupled to a computer system bus.

The algorithms and displays presented herein are not inherently related to any particular computer or other apparatus. Various general-purpose systems can be used with programs in accordance with the teachings herein, or it can prove convenient to construct a more specialized apparatus to perform the method. The structure for a variety of these systems will appear as set forth in the description above. In addition, the present disclosure is not described with reference to any particular programming language. It will be appreciated that a variety of programming languages can be used to implement the teachings of the disclosure as described herein.

The present disclosure can be provided as a computer program product, or software, that can include a machine-readable medium having stored thereon instructions, which can be used to program a computer system (or other electronic devices) to perform a method according to the present disclosure. A machine-readable medium includes any mechanism for storing information in a form readable by a machine (e.g., a computer). In some embodiments, a machine-readable (e.g., computer-readable) medium includes a machine-readable (e.g., computer-readable) storage medium such as a ROM, RAM, magnetic disk storage media, optical storage media, flash memory components, and so forth.

In the foregoing specification, embodiments of the disclosure have been described with reference to specific example embodiments thereof. It will be evident that various modifications can be made thereto without departing from the broader spirit and scope of embodiments of the disclosure as set forth in the following claims. The specification and drawings are, accordingly, to be regarded in an illustrative sense rather than a restrictive sense.

Further embodiments are set out in the following clauses in which:
1. A system comprising:
   a set of memory components of a memory sub-system;
   a processing device operatively coupled to the set of memory components; and
   a thermally conductive material (TCM) surrounding the set of memory components and the processing device, the TCM configured to dissipate heat from the processing device and the set of memory components, wherein the processing device is configured to perform operations comprising:
      measuring temperature of at least one of the processing device or the set of memory components;
      accessing a reference temperature for controlling a data transfer rate between a host and the set of memory components;
      comparing the measured temperature with the reference temperature; and
   adjusting the data transfer rate based on the comparing the measured temperature with the reference temperature.
2. The system of clause 1, comprising a printed circuit board (PCB) on which the set of memory components, the processing device, and the TCM are implemented.
3. The system of clause 2, wherein the processing device is implemented by a physical chip having a specified height relative to a top layer of the PCB; and wherein a height of the TCM is less than or equal to the specified height of the physical chip.
4. The system of clause 2, wherein the set of memory components is implemented by one or more physical chips each having a specified height relative to a top layer of the PCB; and
   wherein a height of the TCM is less than or equal to the specified height of the one or more physical chips.
5. The system of clause 4, wherein the specified height comprises 1.5 millimeters.
6. The system of clause 1, wherein a PCB comprises an M.2 interface through which the set of memory components and the processing device communicate with a host, the TCM being deposited on the PCB.
7. The system of clause 6, wherein the PCB comprises one or more passive or active components; and
   wherein the TCM encapsulates the one or more passive or active components.
8. The system of clause 1, wherein the TCM comprises a heat sink.
9. The system of clause 1, wherein the TCM is thermally coupled to walls of physical chips that implement the processing device and the set of memory components.
10. The system of clause 1, wherein the TCM comprises a potting material comprising a thermal epoxy.
11. The system of clause 10, wherein the thermal epoxy comprises a 1 W/m-K thermal conductivity.
12. The system of clause 1, wherein the TCM comprises a phase change material (PCM).
13. The system of clause 12, wherein the PCM comprises a 0.7 W/m-K thermal conductivity.
14. The system of clause 1, wherein the TCM comprises a first type of material and a second type of material, the first type of material surrounding the processing device and the second type of material surrounding the set of memory components.
15. The system of clause 1, wherein a portion of the TCM is removable by applying a debonding liquid to access one or more circuit components covered by the TCM for debugging the memory sub-system.
16. The system of clause 1, wherein the TCM is configured to absorb physical shock to the memory sub-system to add stability to the memory sub-system; and wherein underfill material is excluded from being deposited underneath the set of memory components or the processing device.
17. A method comprising:
   measuring temperature of at least one of a processing device or a set of memory components, wherein heat associated with the at least one of the processing device or the set of memory components is dissipated at least in part through a thermally conductive material (TCM) that surrounds the set of memory components and the processing device;
   accessing a reference temperature for controlling a data transfer rate between a host and the set of memory components;
   comparing the measured temperature with the reference temperature; and adjusting the data transfer rate based on the comparing the measured temperature with the reference temperature.
18. The method of clause 17, wherein the processing device is implemented by a physical chip having a specified height relative to a top layer of a printed circuit board (PCB); and
   wherein a height of the TCM is less than or equal to the specified height of the physical chip.
19. The method of clause 18, wherein the set of memory components is implemented by one or more physical chips each having a specified height relative to a top layer of the PCB; and
   wherein a height of the TCM is less than or equal to the specified height of the one or more physical chips.
20. A method of manufacturing a printed circuit board (PCB) comprising a memory system, the method comprising:
   placing a processing device on a first portion of the PCB;
   placing a set of memory components of the memory system on a second portion of the PCB; and
   depositing thermally conductive material (TCM) on the PCB to surround the set of memory components and the processing device.

## Claims

1. A system comprising:
a set of memory components of a memory sub-system;
a processing device operatively coupled to the set of memory components; and
a thermally conductive material "TCM" surrounding the set of memory components and the processing device, the TCM configured to dissipate heat from the processing device and the set of memory components, wherein the processing device is configured to perform operations comprising:
measuring temperature of at least one of the processing device or the set of memory components;
accessing a reference temperature for controlling a data transfer rate between a host and the set of memory components;
comparing the measured temperature with the reference temperature; and
adjusting the data transfer rate based on the comparing the measured temperature with the reference temperature.

2. The system of claim 1, comprising a printed circuit board 'PCB' on which the set of memory components, the processing device, and the TCM are implemented.

3. The system of claim 2, wherein the processing device is implemented by a physical chip having a specified height relative to a top layer of the PCB; and
wherein a height of the TCM is less than or equal to the specified height of the physical chip.

4. The system of claim 2, wherein the set of memory components is implemented by one or more physical chips each having a specified height relative to a top layer of the PCB; and
wherein a height of the TCM is less than or equal to the specified height of the one or more physical chips and optionally wherein the specified height comprises 1.5 millimeters.

5. The system of claim 1, wherein a PCB comprises an M.2 interface through which the set of memory components and the processing device communicate with a host, the TCM being deposited on the PCB, and optionally wherein the PCB comprises one or more passive or active components; and
wherein the TCM encapsulates the one or more passive or active components.

6. The system of claim 1, wherein the TCM comprises a heat sink, or is thermally coupled to walls of physical chips that implement the processing device and the set of memory components.

7. The system of claim 1, wherein the TCM comprises a potting material comprising a thermal epoxy and optionally wherein the thermal epoxy comprises a 1 W/m-K thermal conductivity.

8. The system of claim 1, wherein the TCM comprises a phase change material (PCM) and optionally wherein the PCM comprises a 0.7 W/m-K thermal conductivity.

9. The system of claim 1, wherein the TCM comprises a first type of material and a second type of material, the first type of material surrounding the processing device and the second type of material surrounding the set of memory components.

10. The system of claim 1, wherein a portion of the TCM is removable by applying a debonding liquid to access one or more circuit components covered by the TCM for debugging the memory sub-system.

11. The system of claim 1, wherein the TCM is configured to absorb physical shock to the memory sub-system to add stability to the memory sub-system; and
wherein underfill material is excluded from being deposited underneath the set of memory components or the processing device.

12. A method comprising:
measuring temperature of at least one of a processing device or a set of memory components, wherein heat associated with the at least one of the processing device or the set of memory components is dissipated at least in part through a thermally conductive material "TCM" that surrounds the set of memory components and the processing device;
accessing a reference temperature for controlling a data transfer rate between a host and the set of memory components;
comparing the measured temperature with the reference temperature; and
adjusting the data transfer rate based on the comparing the measured temperature with the reference temperature.

13. The method of claim 12, wherein the processing device is implemented by a physical chip having a specified height relative to a top layer of a printed circuit board (PCB); and
wherein a height of the TCM is less than or equal to the specified height of the physical chip.

14. The method of claim 13, wherein the set of memory components is implemented by one or more physical chips each having a specified height relative to a top layer of the PCB; and
wherein a height of the TCM is less than or equal to the specified height of the one or more physical chips.

15. A method of manufacturing a printed circuit board "PCB" comprising a memory system, the method comprising:
placing a processing device on a first portion of the PCB;
placing a set of memory components of the memory system on a second portion of the PCB; and
depositing thermally conductive material "TCM" on the PCB to surround the set of memory components and the processing device.
